# DEMANDE DE BREVET EUROPEEN

(11) **EP 1 195 821 A1**
(43) Date de publication de la demande: **10.04.2002**
(21) Numéro de dépôt: 01402452.5
(22) Date de dépôt: 25.09.2001
(51) Int. Cl.: H01L 43/08, H01F 10/32, G01R 33/09

(54) **Dispositif à vanne de spin à réflexion électronique spectaculaire dépendant du spin**

(30) Priorité: 26.09.2000 FR 0012203
(71) Demandeur: COMMISSARIAT A L'ENERGIE ATOMIQUE, 75752 Paris Cédex 15 (FR)
(72) Inventeur: Dieny, Bernard, 38250 Lans en Vercors (FR)
(74) Mandataire: Signore, Robert

(57) **Abrégé**

Le dispositif comprend une couche non magnétique électriquement conductrice intercalée entre deux couches magnétiques. Selon l'invention, l'une au moins de ces couches magnétiques (R, R', F) présente une réflexion électronique spéculaire dépendant de l'orientation du spin des électrons relativement à la direction d'aimantation.

Application à la réalisation de capteurs de champ magnétique, de têtes de lecture, de mémoires, etc...

## Description

### Domaine technique

La présente invention a pour objet un dispositif à vanne de spin à réflexion électronique spéculaire dépendant du spin. Elle trouve des applications dans la réalisation de capteurs de champ magnétique (pour la robotique ou l'industrie automobile par exemple), dans la réalisation de têtes de lecture pour support d'enregistrement magnétique, de mémoires magnétiques, etc...

### Etat de la technique antérieure

Une vanne de spin (en anglais "spin-valve") est constituée d'un empilement de couches minces avec au moins deux couches ferromagnétiques séparées par une couche intermédiaire non magnétique et électriquement conductrice.

Un tel empilement possède une résistance qui est fonction du champ magnétique appliqué. Le passage d'un courant dans la couche intermédiaire permet de mesurer cette résistance et d'accéder ainsi au champ.

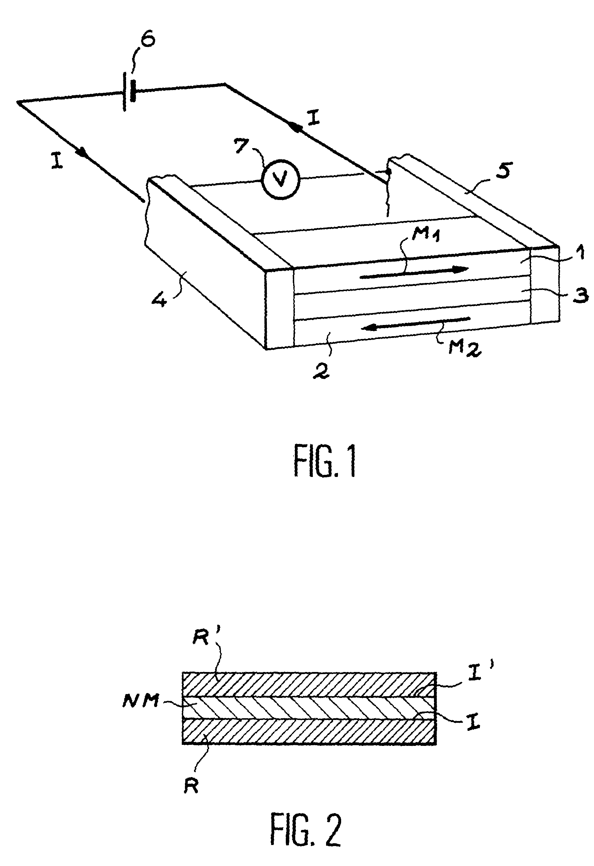

Le brevet US-A-4,949,039 délivré le 14 août 1990 à P. GRUNBERG décrit un tel dispositif. Sa structure est illustrée sur la figure 1 annexée. Sur cette figure, on voit un empilement comprenant une première couche ferromagnétique 1, une seconde couche ferromagnétique 2 et une couche intermédiaire 3 non magnétique et électriquement conductrice. Les matériaux constituant les couches ferromagnétiques 1 et 2 peuvent être le fer, le cobalt, le nickel ou des alliages de ces matériaux avec notamment des corps comme Cu, Cr, Si, Mo, Zr, Zn, V, Al, Mn, B, Tb. La couche intermédiaire peut être en cuivre, en or, en argent, etc...

La première couche magnétique 1 présente une aimantation M1 dirigée par exemple longitudinalement, c'est-à-dire dans la direction de la plus grande dimension du ruban constituant l'empilement. De même, pour l'aimantation M2 de la seconde couche magnétique 2. Ces deux aimantations peuvent être antiparallèles, comme représenté sur la figure, c'est-à-dire que leurs sens sont opposés. Mais elles peuvent être aussi parallèles. C'est le changement d'orientation relative des aimantations de ces deux couches qui s'accompagne d'une variation de résistance électrique de la structure.

L'épaisseur de la couche intermédiaire 3 doit être suffisamment grande pour éviter un couplage direct entre les couches magnétiques 1 et 2, mais suffisamment faible pour être inférieure au libre parcours moyen des électrons de conduction. Une épaisseur de l'ordre de 2 à 5 nm convient en général.

Le phénomène physique sur lequel repose ce dispositif est lié à la diffusion des électrons de conduction dans les couches magnétiques ou aux interfaces entre ces couches et la couche intermédiaire, diffusion dont le taux dépend de l'orientation du spin de ces électrons par rapport à l'aimantation du voisinage. Si les deux aimantations sont parallèles, une catégorie d'électrons (par exemple les électrons de spin parallèle aux aimantations) est faiblement diffusé dans les deux couches magnétiques. Ces électrons peuvent donc transporter beaucoup de courant ce qui conduit à un état de forte conductivité électrique.

Si, par contre, les deux aimantations sont antiparallèles, les deux catégories d'électrons (ceux de spin parallèle et antiparallèle à l'aimantation locale) sont fortement diffusés dans l'une ou l'autre des couches magnétiques. La conductivité électrique est donc réduite par rapport à la situation d'alignement parallèle des aimantations. Ce phénomène est connu sous le nom de magnétorésistance géante.

La résistance est donc plus grande avec des aimantations antiparallèles que parallèles.

Pour contrôler l'orientation relative des aimantations, on piège habituellement l'aimantation d'une des couches magnétiques par couplage d'échange avec une couche antiferromagnétique (par exemple PtMn ou PdPtMn). La couche dont on fixe l'aimantation porte habituellement le nom de couche piégée ("pinned layer" en anglais). La couche antiferromagnétique introduite pour piéger l'aimantation de la couche ferromagnétique adjacente s'appelle couche piégeante ("pinning layer" en anglais).

L'aimantation de l'autre couche magnétique constituée d'un matériau magnétiquement doux (par exemple Ni₈₀Fe₂₀) est au contraire libre de suivre les variations du champ magnétique appliqué au système. Cette couche porte le nombre de couche libre (ou "free layer" en anglais). L'application d'un champ magnétique conduit ainsi à une modification de l'orientation relative des aimantations des deux couches magnétiques laquelle s'accompagne d'une variation de résistance électrique de l'empilement. Pour mesurer cette variation de résistance, il suffit de prévoir deux conducteurs 4 et 5 reliés à une source de courant 6 et de faire circuler un courant I dans l'empilement (en pratique, dans la couche intermédiaire 3). Un appareil 7 mesure la tension aux bornes de l'empilement. A courant constant, la variation de tension reflète la variation de résistance, donc la valeur du champ appliqué.

De nombreux perfectionnements ont été apportés à ces structures depuis leur invention en 1990 : utilisation de couches piégées synthétiques, introduction dans les couches douces et piégées de couches minces d'oxydes augmentant la réflexion spéculaire des électrons aux interfaces, remplacement d'une partie de la couche magnétique par une couche non-magnétique de haute conductivité ("spin-filter spin-valve").

Les valeurs de résistances actuellement obtenues sont de l'ordre de 8 à 15% à température ambiante, le changement absolu de résistance entre les configurations parallèle et antiparallèle est de l'ordre de 2 à 2,50 Ω par carré. Ces structures conviennent pour une densité de stockage de l'information de 50 Gbits/pouce², soit environ 8 Gbit/cm².

Cependant, l'accroissement constant de la capacité d'information stockée sur les disques durs (accroissement de plus de 60% par an) nécessite de toujours augmenter la sensibilité de l'élément magnétorésistif servant à la relecture de l'information stockée. De ce fait, il faut trouver des moyens pour augmenter encore l'amplitude de la magnétorésistance de ces vannes de spin.

### Exposé de l'invention

A cette fin, l'invention propose une vanne de spin à base de couches magnétiques présentant des coefficients de réflexion spéculaire des électrons dépendant de la direction du spin des électrons relativement à l'aimantation des couches magnétiques. Cette propriété est différente de celle qui est utilisée dans l'art antérieur où c'est la diffusion se produisant aux interfaces (ou dans le volume des couches magnétiques) qui dépend de la direction du spin.

De façon précise, la présente invention a pour objet un dispositif à vanne de spin comprenant au moins un empilement de couches comprenant une couche non magnétique électriquement conductrice intercalée entre une première et une deuxième couches magnétiques, la première et la deuxième couches magnétiques ayant une aimantation présentant une certaine direction, ce dispositif étant caractérisé en ce que l'une au moins desdites première et deuxième couches magnétiques présente, à l'interface avec la couche non magnétique, une réflexion spéculaire pour les électrons de conduction qui dépend de l'orientation du spin des électrons relativement à la direction d'aimantation dans la(les) couche(s) magnétique(s).

Trois variantes sont notamment proposées :
**1) variante 1 :** la structure comprend un empilement de la forme R/NM/R' où R et R' désignent deux couches magnétiques présentant une réflexion spéculaire des électrons dépendante du spin (par exemple Fe₃O₄), NM désigne une couche non-magnétique bonne conductrice du courant électrique (par exemple du cuivre). L'épaisseur de la couche NM est inférieure à quelques fois le libre parcours des électrons dans cette couche (typiquement inférieure à 10 nm) ;
**2) variante 2 :** la structure comprend un empilement de la forme R/NM/F où R et NM ont le même sens que précédemment et F désigne une couche ferromagnétique permettant une diffusion dépendante du spin des électrons, se produisant à l'interface NM/F ou dans le volume de la couche F. La couche F peut être par exemple, une couche d'un métal de transition ou d'alliages de métaux de transition comme le permalloy (Ni₈₀Fe₂₀) ou l'alliage Co₉₀Fe₁₀. L'épaisseur de la couche NM est, comme précédemment, inférieure à quelques fois le libre parcours moyen dans cette couche (typiquement inférieure à 10 nm), celle de la couche F est inférieure au libre parcours moyen des électrons les moins diffusés dans cette couche (les électrons de spin parallèle à l'aimantation dans le permalloy, typiquement 10 nm) ;
**3) variante 3** : la structure comprend un empilement de la forme R/NM/F/NM'/R'. Les couches R et R' ont le même sens que précédemment, NM et NM' sont deux couches non-magnétiques bonnes conductrices du courant électrique, la couche F représente une couche ferromagnétique ou un empilement de couches ferromagnétiques présentant de la diffusion dépendante du spin aux interfaces avec les couches NM et NM' ou dans le volume de F.

Ces trois types d'empilements peuvent être associés à d'autres couches magnétiques ou non disposées de part et d'autre des empilements et destinées à permettre un meilleur contrôle de l'orientation relative des aimantations par application d'un champ magnétique.

### Brève description des dessins

- la figure 1, déjà décrite, montre un dispositif à vanne de spin connu ;
- la figure 2 illustre schématiquement et en coupe un dispositif selon la première variante de l'invention ;
- la figure 3 illustre un mode particulier de réalisation de cette première variante ;
- les figures 4A, 4B et 4C montrent les variations de certaines grandeurs (résistance par carré, magnétorésistance absolue, magnétorésistance relative), propres à la première variante en fonction de l'épaisseur de la couche non-magnétique séparatrice ;
- les figures 5A, 5B et 5C montrent les variations de ces mêmes grandeurs en fonction du coefficient de réflexion spéculaire des électrons à l'interface couche magnétique/couche non magnétique ;
- les figures 6A, 6B, 6C et 6D montrent les variations de certaines grandeurs (résistance par carré, magnétorésistance absolue, magnétorésistance relative et conductance par carré) pour différents contrastes de réflexion spéculaire en fonction de l'épaisseur de la couche non magnétique séparatrice ;
- la figure 7 illustre schématiquement et en coupe un dispositif selon la deuxième variante de l'invention ;
- la figure 8 illustre un mode particulier de réalisation de cette deuxième variante ;
- les figures 9A, 9B et 9C montrent les variations de la résistance par carré, de la magnétorésistance absolue et de la magnétorésistance relative en fonction de l'épaisseur de la couche non magnétique pour la deuxième variante de l'invention ;
- les figures 10A, 10B et 10C montrent les variations de ces mêmes grandeurs en fonction de l'épaisseur de la couche non magnétique séparatrice ;
- la figure 11 illustre schématiquement et en coupe un dispositif selon la troisième variante de l'invention ;
- les figures 12A et 12B montrent les variations de la magnétorésistance relative et absolue d'un dispositif selon la troisième variante en fonction de l'épaisseur de la couche ferromagnétique.

### Description détaillée de modes particuliers de réalisation

L'invention peut être mise en oeuvre de bien des manières. A titre d'exemples non limitatifs, on décrira trois variantes particulières qui semblent avantageuses.

### 1. Première variante : structure de type R/NM/R'

Cette première variante est illustrée sur la figure 2 où l'on voit un empilement comprenant une couche NM intercalée entre une couche R et une couche R'. Les interfaces R/NM et R'/NM sont référencées I et I'.

Les références R et R' représentent des couches magnétiques présentant des effets de réflexion électronique spéculaire dépendants du spin. De nombreux oxydes peuvent présenter ce type d'effet : des couches d'oxydes magnétiques tels que Fe₃O₄, d'autres oxydes ferrimagnétiques à base de nickel, de cobalt ou de fer présentant une structure spinelle, des grenats magnétiques, CrO₂, etc... Des couches de nitrures ferromagnétiques à base de fer et/ou de nickel et/ou de cobalt peuvent aussi présenter de tels effets.

La couche NM est une couche non magnétique conductrice de l'électricité, par exemple en métal comme le cuivre, l'or, l'argent ainsi que tout métal présentant une résistivité suffisamment faible (typiquement inférieure à 20 µΩ.cm).

Toutes ces couches peuvent être déposées sur un substrat isolant ou semiconducteur pour éviter une dérivation du courant à l'extérieur de la partie active de la structure, c'est-à-dire de la couche NM et des couches immédiatement adjacentes. La technique de dépôt peut être la pulvérisation cathodique à partir d'une cible du composé à déposer ou la pulvérisation réactive. D'autres méthodes de dépôt comme l'épitaxie par jet moléculaire, l'ablation laser ou le dépôt en phase vapeur (CVD pour "Chemical Vapor Deposition") peuvent aussi être utilisées.

Les épaisseurs des couches R et R' sont comprises entre un plan atomique et quelques centaines de nm. Etant donné que ces matériaux sont isolants ou très fortement résistifs, ils dérivent peu de courant et leur épaisseur peut donc être relativement importante. Cette épaisseur doit être déterminée par la possibilité de contrôler l'orientation relative des aimantations de ces deux couches R et R'. Afin d'assurer ce contrôle, il est possible de coupler une des couches R ou R', par exemple R, à une couche d'un matériau antiferromagnétique permettant le piégeage de l'aimantation de cette couche (par exemple piéger une couche de Fe₃O₄ en déposant une couche de Fe₂O₃ adjacente). De plus, afin de pouvoir facilement retourner l'aimantation de la couche opposée, R' dans cet exemple, il est possible de choisir l'épaisseur de R' suffisamment fine (de l'ordre de 1 nm) et de la coupler à une couche magnétiquement douce comme du Ni₈₀Fe₂₀ d'épaisseur suffisamment fine (typiquement 1 à 3 nm) pour ne pas dériver trop de courant. La fine couche d'oxyde couplée à la couche douce et présentant une réflexion dépendante du spin peut être aussi formée en déposant d'abord la couche métallique douce puis en l'oxydant en surface par introduction d'oxygène dans la chambre de préparation ou à l'air ou en utilisant un plasma d'oxygène ou un canon à oxygène dissocié ou par toute autre technique d'oxydation utilisées pour la fabrication des barrières d'oxydes dans les jonctions tunnels magnétiques. Ces dernières sont connues de l'homme de l'art.

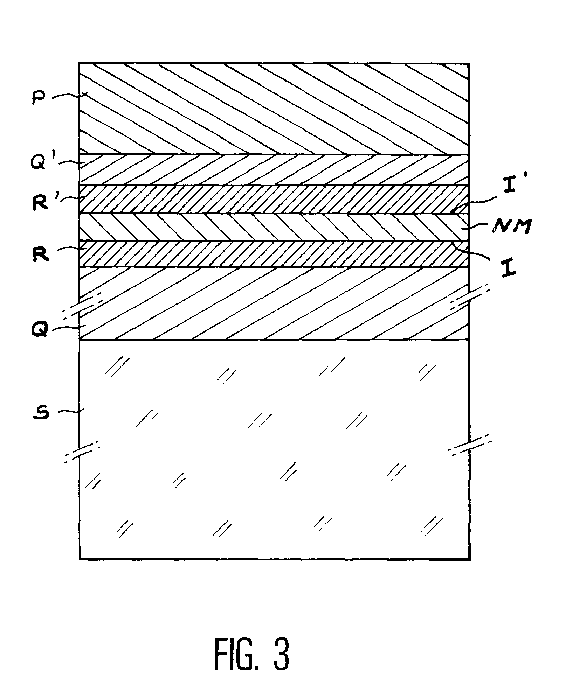

La figure 3 illustre un mode particulier de réalisation de cette première variante. Le dispositif comprend un substrat S, une couche Q, par exemple en Fe₂O₃ d'épaisseur 20 nm, une couche R, par exemple en Fe₃O₄ d'épaisseur 3 nm, une couche NM, par exemple en cuivre de 1,5 nm, une couche R', par exemple de Fe₃O₄ de 1 nm, une couche Q', par exemple en NiFe de 2 nm, et enfin une couche protectrice P, par exemple en Ta.

On peut aussi constituer un empilement symétrique avec un substrat, une couche tampon (Ta, ou alliage NiFeCr), une couche en Ni₈₀Fe₂₀, une couche en Fe₃O₄ (ou NiFeO), une couche de Cu, une couche de Fe₃O₄, une couche de Fe₂O₃.

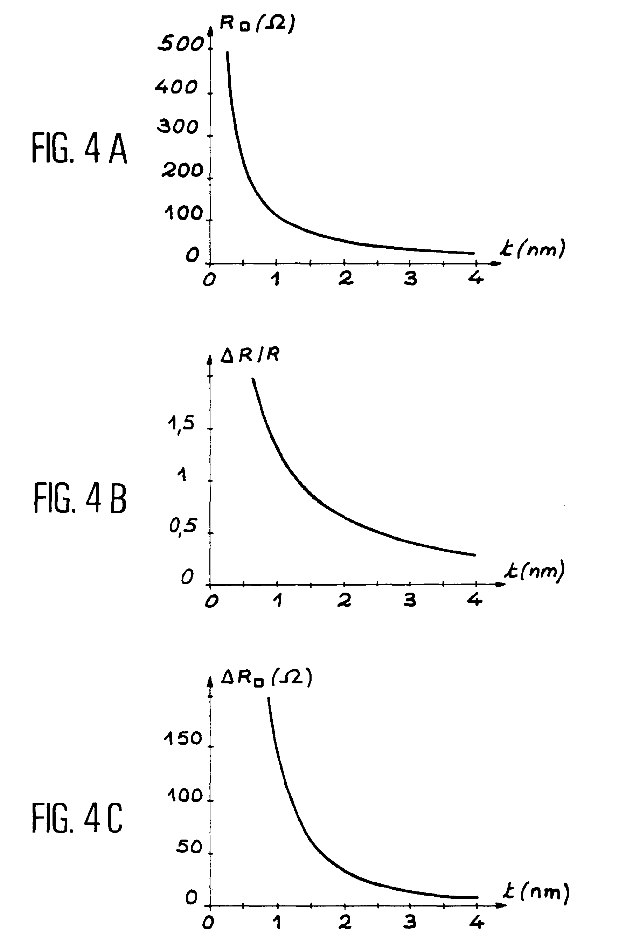

Les figures 4A, 4B et 4C montrent les variations de la résistance par carré (4A), la magnétorésistance relative ΔR/R (4B) et la magnétorésistance absolue par carré (4C) en fonction de l'épaisseur t de la couche non magnétique exprimée en nanomètres.

Ces figures correspondent à des couches R et R' en Fe₃O₄ de 10 nm et une couche NM en cuivre. On a supposé que la réflexion spéculaire était parfaite pour les électrons dont le spin est parallèle à l'aimantation et complètement diffuse pour les électrons dont le spin est antiparallèle (ce qu'on peut noter symboliquement R↑=1 et R↓=0 où R désigne le coefficient de réflexion spéculaire et les flèches le parallélisme (↑) ou l'antiparallélisme (↓) des spins des électrons par rapport à l'aimantation locale du matériau.

Ces figures montrent donc les propriétés de transport que l'on pourrait obtenir dans le cas idéal où la réflexion serait parfaitement spéculaire pour une catégorie d'électrons et totalement diffuse pour l'autre catégorie d'électrons. L'amplitude de magnétorésistance relative peut être extrêmement importante dans ce cas, de plusieurs dizaines de pourcents comparativement à 10 à 15% dans les meilleures vannes de spin disponibles actuellement. L'amplitude de magnétorésistance absolue est particulièrement importante compte tenu de la forte résistance de ces couches. Elle peut atteindre plusieurs dizaines d'Ohms par carré alors qu'elle est de l'ordre de 2 à 3 Ohms dans les meilleures vannes de spin actuelles.

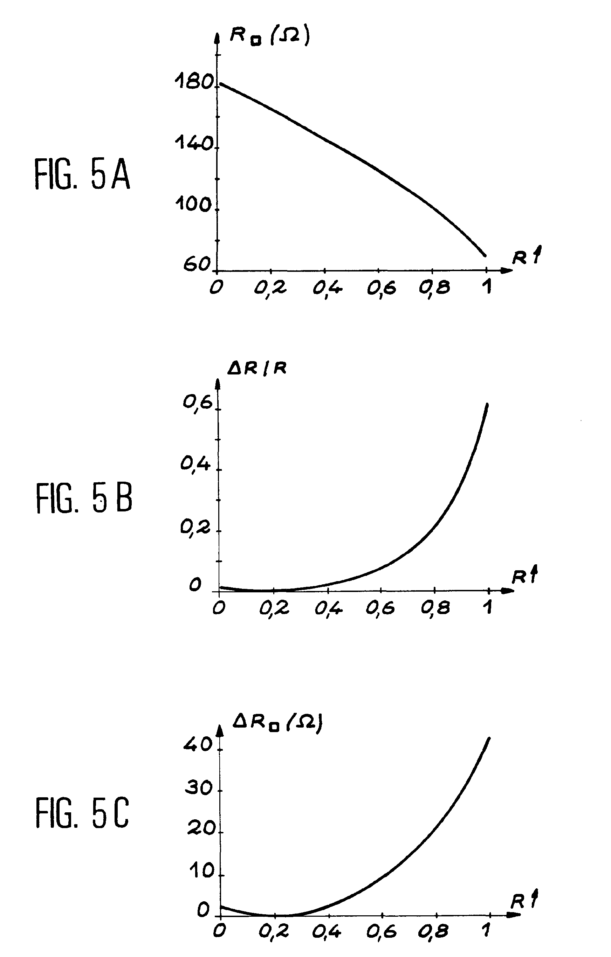

Les figures 5A,5B et 5C montrent les variations de ces mêmes grandeurs pour une épaisseur de la couche non magnétique égale à 1,5 nm en fonction de R↑ sachant que R↓ est pris égal à 0,2. Pour des valeurs réalistes que l'on peut attendre avec des matériaux comme Fe₃O₄, R↑=0,8, R↓=0,2, des amplitudes de magnétorésistance ΔR/R de l'ordre de 20% peuvent être obtenues avec une magnétorésistance absolue de 20 Ω.

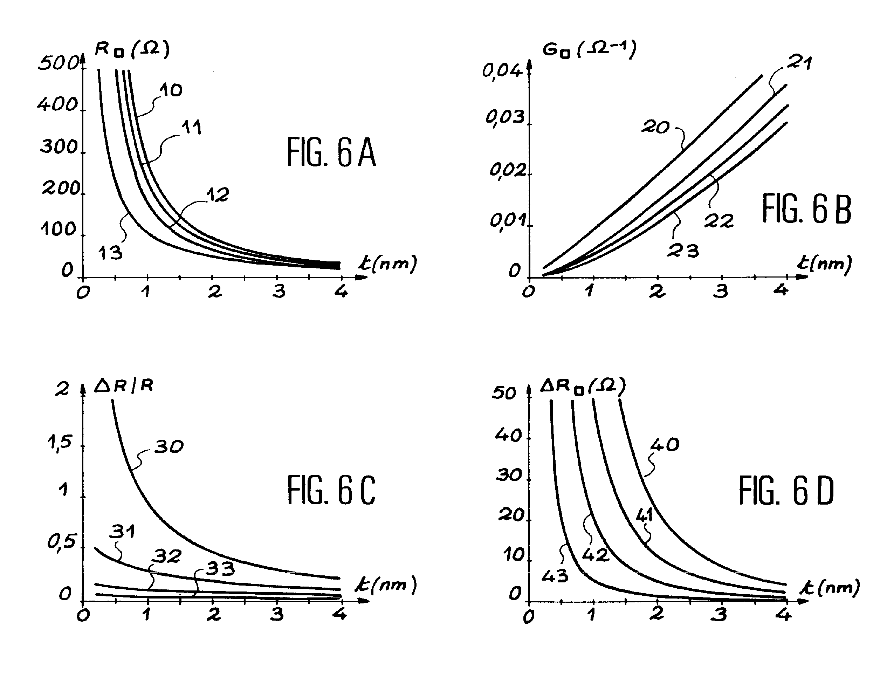

Les figures 6A, 6B, 6C et 6D montrent l'influence de l'épaisseur t de la couche non magnétique séparatrice NM sur les propriétés de transport pour différents contrastes de réflexion. Pour les quatre figures R↓ est pris égal à 0,2. La correspondance entre les différentes courbes et le coefficient de réflexion R↑ est le suivant :

| Figure | Courbe | R↑ |
|---|---|---|
| 6A | 10 | 0,4 |
| | 11 | 0,6 |
| | 12 | 0,8 |
| | 13 | 1 |
| 6B | 20 | 1 |
| | 21 | 0,8 |
| | 22 | 0,6 |
| | 23 | 0,4 |
| 6C | 30 | 1 |
| | 31 | 0,8 |
| | 32 | 0,6 |
| | 33 | 0,4 |
| 6D | 40 | 1 |
| | 41 | 0,8 |
| | 42 | 0,6 |
| | 43 | 0,4 |

### 2. Deuxième variante : structure de type F/NM/R :

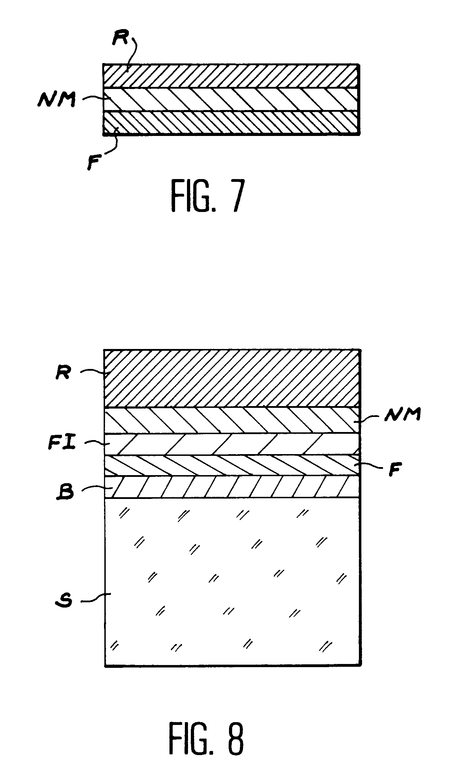

La figure 7 illustre schématiquement un empilement conforme à la deuxième variante de l'invention. L'empilement représenté comprend une couche F, où se produisent des effets de diffusion dépendante du spin, une couche non magnétique NM et une couche R présentant des effets de réflexion électronique dépendante du spin relativement à la direction de l'aimantation dans la couche R. Comme pour les vannes de spin actuelles, la couche F peut être associée à une couche d'un autre matériau ferromagnétique insérée entre les couches F et NM afin d'augmenter la diffusion dépendante du spin à l'interface F/NM. Cette couche est communément en Co₉₀Fe₁₀. De plus, la couche F peut être déposée sur une couche tampon destinée à promouvoir la croissance de la structure (par exemple en Ta ou alliage NiFeCr). Une partie de la couche F peut également être remplacée par une couche conductrice non magnétique, par exemple de Cu ou de Ru. C'est la configuration de "spin-filter spin-valve" connue dans le contexte des vannes de spin actuelles. La structure est alors de la forme : couche tampon (NiFeCr, typiquement 5 nm)/couche conductrice non magnétique (typiquement Cu 2 nm)/couche ferromagnétique douce (typiquement Co₉₀Fe₁₀ 2 nm)/couche séparatrice non magnétique (typiquement Cu 2 nm)/couche réflective sélective en spin (par exemple Fe₃O₄) 20 nm/couche de piégeage non conductrice (par exemple Fe₂O₃).

Il est également possible d'introduire à l'interface de la couche F opposée à la couche NM une fine couche d'oxyde ou une couche de Ru destinée à réfléchir les électrons en direction de la couche séparatrice NM. C'est ce qui est fait actuellement dans les vannes de spin en introduisant des couches d'oxyde d'épaisseur subnanométrique pour augmenter la réflexion spéculaire des électrons.

La configuration "spin-filter spin-valve", ou l'introduction d'une réflexion spéculaire dans la couche ferromagnétique douce permet de réduire l'épaisseur de la couche magnétique, ce qui augmente la sensibilité du capteur de champ magnétique. En effet, pour une quantité de flux magnétique donnée pénétrant dans le capteur, l'aimantation de la couche douce tournera d'autant plus sous l'effet du champ appliqué que l'épaisseur de cette couche sera faible.

Cette deuxième variante de réalisation permet de vérifier si un matériau R présente des effets de réflexion dépendante du spin à l'interface R/NM. Il suffit, en effet, de réaliser une structure de la forme substrat (par exemple Si)/Ta 5 nm/Ni₈₀Fe₂₀ 4 nm/Co₉₀Fe₁₀ 1 nm/Cu 2,5 nm/R 20 nm puis de mesurer la résistance de cette structure dans un champ variant de -100 Oe à +100 Oe dans lequel on est sûr que l'aimantation de la couche de NiFe/CoFe aura basculé. Si l'on observe un effet de magnétorésistance lié au passage du parallélisme à l'antiparallèlisme des aimantations de F et R, alors le matériau R présente une réflexion dépendante du spin que l'on peut quantifier à l'aide d'une théorie semi-classique. Si, au contraire, aucun changement de résistance n'est observé, alors le matériau R peut présenter de la réflexion spéculaire mais celle-ci ne dépend pas du spin de l'électron.

La figure 8 montre une structure de ce genre avec un substrat S, une couche tampon B, une couche F, une couche ferromagnétique interfaciale FI, une couche NM et une couche R.

Le matériau F est un matériau doux dont l'aimantation peut facilement suivre les variations du champ appliqué alors que l'aimantation R est piégée soit parce que R est un matériau magnétiquement dur, soit parce que l'aimantation de R est couplée à un matériau antiferromagnétique, de préférence isolant, comme Fe₂O₃.

L'avantage de ces structures de la deuxième variante par rapport à celle de la première est que les matériaux utilisés pour F peuvent être les mêmes que dans les vannes de spin classiques (permalloy, alliages CoFe, CoFeB, ...). L'homme de l'art sait donc facilement réaliser cette couche de matériau magnétique doux. Par contre, dans les structures de la première variante, c'est une des couches R ou R' qui doit être magnétiquement douce. C'est moins facile à réaliser car les matériaux susceptibles de présenter les effets de réflexion spéculaire dépendante du spin sont a priori plutôt des matériaux durs. C'est pourquoi, comme discuté précédemment, il faut associer ce matériau R à une couche de matériau doux pour augmenter sa susceptibilité magnétique. Mais ceci a pour effet de dériver une partie du courant dans cette couche douce ce qui abaisse les performances de magnétorésistance.

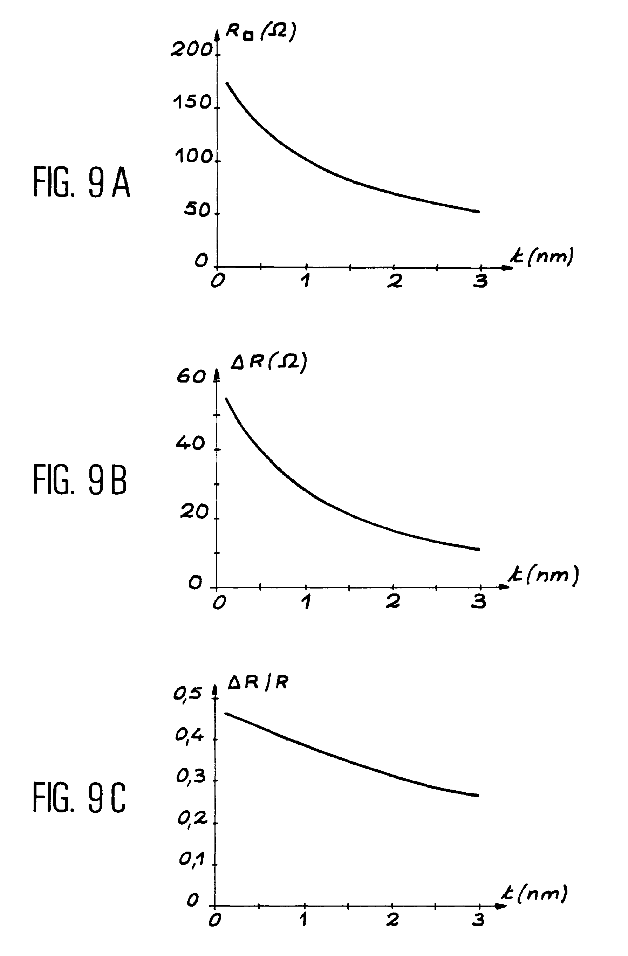

Dans les structures de la deuxième variante, le changement de l'orientation relative des aimantations de F et de R produit un changement de résistance électrique de la structure. Ceci est illustré sur les figures 9A, 9B et 9C d'une part, et 10A, 10B, 10C d'autre part. Les matériaux et les paramètres relatifs à ces résultats sont les suivants :

| **Structure :** | |
|---|---|
| couche tampon | NiFeCr |
| couche F | Ni₈₀Fe₂₀ |
| couche F intermédiaire | Co₉₀Fe₁₀ |
| couche NM | Cu |
| couche R | oxyde magnétique |

| **Paramètres en volume :** | | |
|---|---|---|
| matériau | libre parcours moyen (nm) spin ↑ | libre parcours moyen (nm) spin ↓ |
| NiFeCr | 0,4 | 0,4 |
| Ni₈₀Fe₂₀ | 7 | 0,7 |
| Co₉₀Fe₁₀ | 9 | 0,9 |
| Cu | 12 | 12 |

| **Paramètres aux interfaces :** | | | | |
|---|---|---|---|---|
| Interface | Transmission ↑ | Transmission ↓ | Réflexion ↑ | Réflexion ↓ |
| NiFeCr/NiFe | 0 | 0 | 0,3 | 0,3 |
| NiFe/CoFe | 1 | 1 | 0 | 0 |
| CoFe/Cu | 1 | 0,5 | 0 | 0 |
| Cu/R | 0 | 0 | 0,8 | 0 |

On a en outre R↑ = 0,8 et R↓ = 0 à l'interface NM/R

Les figures 9A, 9B et 9C montrent les variations de la résistance R, de la magnétorésistance absolue ΔR et de la magnétorésistance relative ΔR/R en fonction de l'épaisseur de la couche F exprimée en nm.

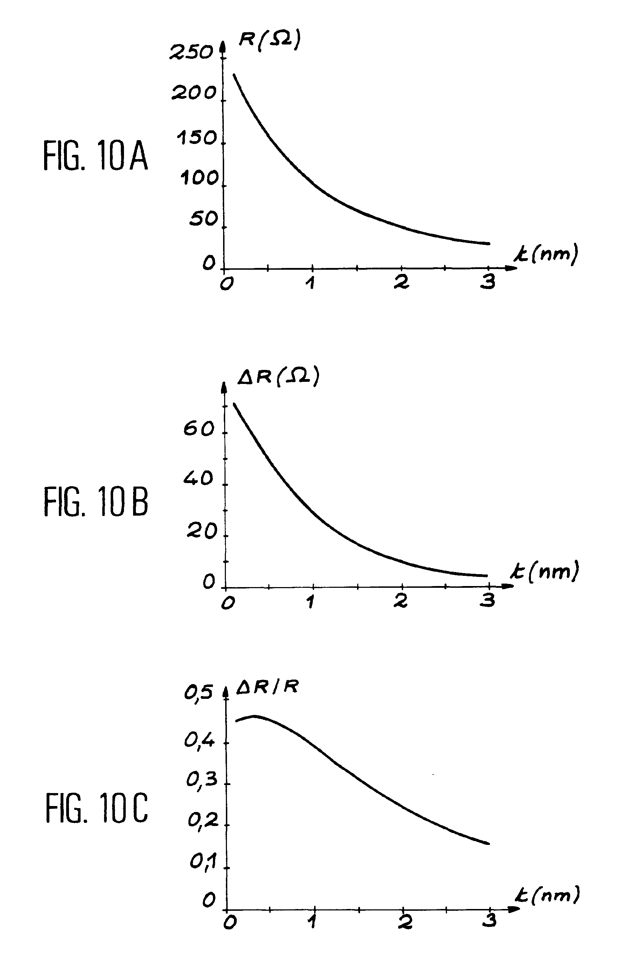

Les figures 10A, 10B et 10C montrent les variations de ces mêmes grandeurs en fonction de l'épaisseur de la couche séparatrice non magnétique NM.

Comme pour les structures de la première variante, de très importantes amplitudes de magnétorésistance peuvent être obtenues. L'épaisseur de la couche NM doit être la plus fine possible tout en préservant le découplage magnétique entre les couches F et R (typiquement entre 1 et 3 nm). La couche F doit être relativement fine aussi (typiquement moins de 5 nm).

### 3. Troisième variante : structure de type R/NM/F/NM/R'

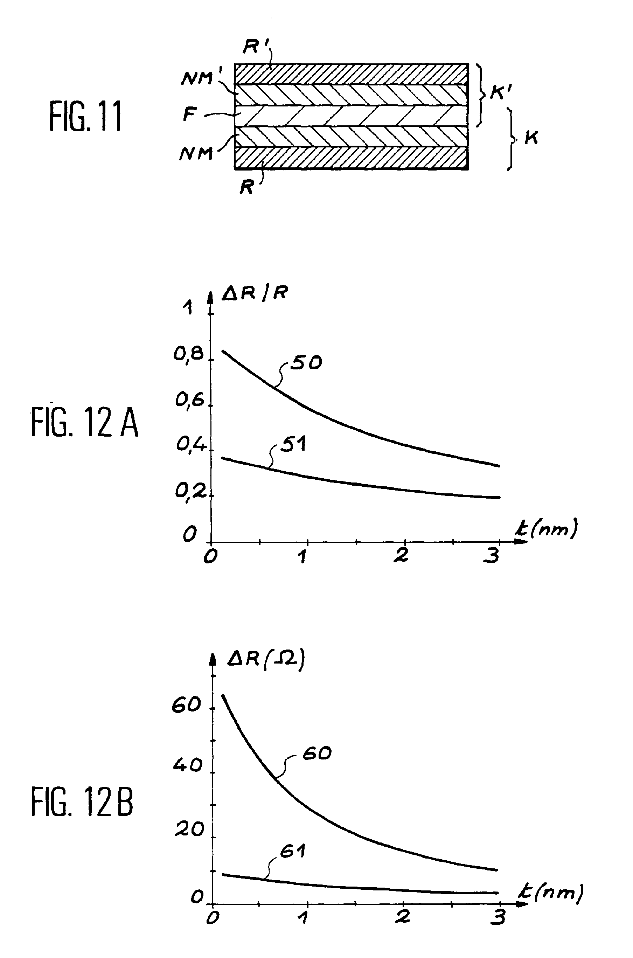

Cette troisième variante est illustrée sur la figure 11. Un premier empilement K comprend les couches R/NM/F tandis qu'un deuxième empilement K' comprend les couches F/NM'/R'. La couche F est donc commune aux deux empilements.

Ces structures présentent une certaine analogie avec les vannes de spin duales connues. La couche magnétique douce, qui répond aux variations du champ appliqué, est insérée dans le plan médian de la structure. Cette couche est séparée des deux couches magnétiques R et R' présentant des effets de réflexion dépendante du spin par deux couches non magnétiques NM typiquement en cuivre de 2 nm d'épaisseur. Les aimantations des couches R et R' sont piégées comme dans les structures précédemment décrites.

Les propriétés de ces structures sont représentées sur les figures 12A et 12B pour les paramètres suivants :

| **Paramètres en volume** | | |
|---|---|---|
| matériau | libre parcours moyen (nm) spin ↑ | libre parcours moyen (nm) spin ↓ |
| NM (Cu) | 12 | 12 |
| Co₉₀Fe₁₀ | 9 | 0,9 |

| **Paramètres aux interfaces** | | | | |
|---|---|---|---|---|
| interface | Transmission ↑ | Transmission ↓ | Réflexion ↑ | Réflexion ↓ |
| R/NM | 0 | 0 | 0,8 | 0 |
| NM/F | 1 | 0,5 | 0 | 0 |
| F/NM | 1 | 0,5 | 0 | 0 |
| NM/R | 0 | 0 | 0,8 | 0 |

La figure 12A montre les variations de la magnétorésistance relative ΔR/R en fonction de l'épaisseur de la couche F avec une épaisseur de la couche NM égale respectivement à 1 nm (courbe 50) et 2 nm (courbe 51).

La figure 12B montre les variations de la magnétorésistance absolue en fonction de l'épaisseur de la couche F, pour une épaisseur de la couche NM égale respectivement à 1 nm (courbe 60) et 2 nm (courbe 61).

## Revendications

1. Dispositif à vanne de spin comprenant au moins un empilement de couches comprenant une couche non magnétique (NM) électriquement conductrice intercalée entre une première (R) et une deuxième (R', F) couches magnétiques, la première (R) et la deuxième (R', F) couches magnétiques ayant une aimantation présentant une certaine direction, **caractérisé en ce que** l'une au moins desdites première et deuxième couches (R, R', F) magnétiques présente, à l'interface avec la couche non magnétique (NM), une réflexion spéculaire pour les électrons de conduction qui dépend de l'orientation du spin des électrons relativement à la direction d'aimantation dans la(les) couche(s) magnétique(s).

2. Dispositif selon la revendication 1, dans lequel la (les) couche(s) magnétique(s) (R, R') présentant une réflexion spéculaire est (sont) en un matériau pris dans le groupe comprenant les oxydes ferrimagnétiques à base de fer et/ou de nickel et/ou de cobalt et/ou de chrome ou les nitrures ferromagnétiques à base de fer et/ou de nickel et/ou de cobalt.

3. Dispositif selon la revendication 1, dans lequel la couche non magnétique (NM) électriquement conductrice est en métal pris dans le groupe comprenant le cuivre, l'argent, l'or.

4. Dispositif selon la revendication 3, dans laquelle la couche non magnétique (NM) électriquement conductrice a une épaisseur inférieure à environ 10 nm.

5. Dispositif selon la revendication 1, comprenant en outre une couche anti-ferromagnétique adjacente à l'une au moins desdites première et deuxième couche magnétiques (R, R').

6. Dispositif selon la revendication 1, dans lequel l'empilement est déposé sur un substrat (S).

7. Dispositif selon la revendication 1, dans lequel l'empilement est recouvert d'une couche de protection (P).

8. Dispositif selon la revendication 1, dans lequel la première (R) et la deuxième (R') couches magnétiques présentent chacune ladite réflexion spéculaire des électrons.

9. Dispositif selon la revendication 1, dans lequel la première couche magnétique (R) présente une réflexion spéculaire des électrons, la deuxième couche magnétique (F) ne présentant pas cette réflexion spéculaire mais présentant une diffusion des électrons dépendante de l'orientation du spin des électrons relativement à la direction de l'aimantation dans cette deuxième couche (F).

10. Dispositif selon la revendication 9, dans lequel la deuxième couche magnétique (F) présentant une diffusion des électrons est en un matériau pris dans le groupe comprenant les métaux de transition, les alliages à base de nickel et/ou de fer et/ou de cobalt.

11. Dispositif selon la revendication 10, comprenant en outre une couche ferromagnétique adjacente à la deuxième couche magnétique (F).

12. Dispositif selon la revendication 1, dans lequel un premier empilement de couches (K) comprend une première couche non magnétique électriquement conductrice (NM) intercalée entre une première couche magnétique (R) et une seconde couche magnétique (F) et un second empilement (K') de couches comprenant une première couche non magnétique et électriquement conductrice (NM') intercalée entre une première couche magnétique (F) et une seconde couche magnétique (R'), la deuxième couche magnétique du premier empilement (K) étant confondue avec la première couche magnétique du second empilement (K'), cette couche (F) présentant une diffusion des électrons dépendant de l'orientation du spin des électrons, la première couche magnétique (R) du premier empilement (K) et la deuxième couche magnétique (R') du second empilement (K') présentant chacune une réflexion spéculaire des électrons dépendant de l'orientation des électrons.
